# FASCICULE DE BREVET EUROPEEN

(11) **EP 3 903 547 B1**
(45) Date de publication et mention de la délivrance du brevet: **17.07.2024**
(21) Numéro de dépôt: 19848874.4
(22) Date de dépôt: 18.12.2019
(51) Int. Cl.: H05K 1/18, H05K 3/40, H05K 3/28

(54) **CARTE ELECTRONIQUE ET PROCEDE DE FABRICATION ASSOCIE**
ELEKTRONISCHE PLATINE UND DEREN HERSTELLUNGSVERFAHREN
ELECTRONIC BOARD AND MANUFACTURING PROCESS THEREOF

(30) Priorité: 26.12.2018 FR 1874169
(43) Date de publication de la demande: 03.11.2021
(73) Titulaire: IDEMIA France, 92400 Courbevoie (FR)
(72) Inventeur: BOSQUET, Olivier, 92400 COURBEVOIE (FR); HUET, Mickaël, 92400 COURBEVOIE (FR); GAC, Philippe, 92400 COURBEVOIE (FR); LAVARENNE, Rémi, 92400 COURBEVOIE (FR)
(74) Mandataire: Idemia
(86) Numéro de dépôt international: PCT/FR2019/053168
(87) Numéro de publication internationale: WO 2020/136328

(56) Documents cités:
- EP-A1- 2 871 595
- WO-A1-2010/115603
- US-A- 5 420 377

## Description

La présente invention concerne une carte électronique comportant un ensemble comportant un FPC (pour « flexible printed circuit »). Elle concerne aussi un procédé de réalisation d'une carte électronique correspondante.

Une carte électronique telle que considérée ici comporte typiquement un corps et au moins un composant électronique intégré dans le corps, soit au sein du corps, soit dans une cavité formée dans le corps et débouchant à une surface du corps. Généralement, plusieurs composants électroniques sont présents.

Un composant électronique placé dans une cavité du corps et débouchant à une surface du corps est par exemple un module encarté.

Une carte électronique telle que considérée ici peut aussi être une carte dite « complexe », qui comporte souvent un circuit imprimé sur un support flexible, dit FPC (pour « flexible printed circuit »). Autrement dit, un FPC comporte typiquement un support relativement souple et flexible et un circuit électronique (i.e. principalement des pistes, généralement en cuivre) imprimé sur le support.

Ce support est par exemple réalisé en un matériau polymère, par exemple en polyimide, par exemple, en Kapton^{®} ou PEN (polyethylene Naphtalate) qui résiste à des hautes températures (typiquement jusqu'à 250°).

En outre, un FPC peut, par exemple, comporter une antenne.

Une telle antenne sert par exemple à communiquer avec un lecteur, externe à la carte, par exemple par communication sans contact.

L'antenne est par exemple formée en spirale.

Elle est par exemple disposée selon le contour du FPC.

En dimensions, le FPC présente donc une hauteur et une largeur, selon un plan du support, chacune inférieure à une hauteur et une largeur du corps de carte correspondante, et une épaisseur (orthogonale à sa hauteur et sa largeur), inférieure à une épaisseur du corps de la carte. La hauteur et la largeur du FPC permettent alors de définir le contour du FPC.

Le FPC est habituellement compris dans une épaisseur de la carte et est, en général, disposé dans une cavité d'une couche intermédiaire, l'ensemble étant noyé dans une résine puis interposé entre deux autres couches contribuant à former le corps de la carte.

Traditionnellement, afin d'établir une connexion entre le circuit électronique du FPC et un composant électronique de la carte, le circuit électronique comporte au moins une plaque de contact. A titre d'exemple, il peut s'agir des extrémités de l'antenne si le FPC en comporte une.

On entend ici par plaque de contact un élément ayant une surface configurée pour établir une connexion électrique avec un autre élément, mais d'épaisseur négligeable. Une telle plaque de contact est généralement incrustée dans un support correspondant, ou posée sur une surface du support puis laminée avec ce support de sorte à ne pas former de surépaisseur, ou au pire une surépaisseur d'épaisseur négligeable, par rapport à cette surface.

Pour établir la connexion électrique, une goutte de pâte de soudure, c'est-à-dire de la pâte dans un état liquide, est déposée sur le support du FPC, en particulier sur la plaque de connexion. Ensuite la goutte durcit, formant ainsi, par définition, une bosse de soudure.

Or, une telle goutte peut présenter une hauteur très variable par rapport à la surface du FPC sur lequel elle est déposée.

Ces variations de hauteur de la bosse de soudure résultent principalement de la géométrie de la goutte (déposée à l'état liquide sur le support) induite par une tension de surface de la pâte de soudure liquide.

En outre, pour réaliser une surface de contact avec laquelle la connexion du composant électronique est ensuite soudée, la bosse est généralement usinée, par exemple par fraisage.

Or, pour obtenir une surface ayant une dimension voulue, il est nécessaire d'usiner la bosse sur une certaine profondeur par rapport à un sommet de la bosse.

Cependant, compte tenu des variations de hauteur, et de forme, possibles, il est difficile de déterminer et maîtriser la profondeur selon laquelle l'usinage doit être réalisé pour obtenir la surface de contact de dimension voulue.

La surface de contact formée par usinage de la bosse a donc un diamètre plus ou moins grand en fonction de la hauteur et de la forme de la bosse, pour un usinage réalisé jusqu'à une même hauteur par rapport à une surface du FPC (donc de profondeur variable par rapport au sommet de la bosse).

Cette variation de dimension de la surface de contact a ensuite une conséquence sur les tolérances acceptables de positionnement du FPC dans le corps de carte.

Les variations de position possibles du FPC dans le corps de carte, couplées aux variations possibles de dimension des surfaces de contact résultent en des tailles de surfaces de connexions disponibles théoriques très réduites.

En conséquence, une carte dans laquelle une goutte de soudure est utilisée pour réaliser une connexion électrique a généralement un faible rendement de fabrication.

De plus, le processus de fabrication nécessite souvent un équipement et des matériaux spécifiques.

Le document EP 2 871 595 divulgue une carte à puce dans laquelle un module électronique est encarté et électriquement connecté à un circuit électrique noyé dans le corps de carte au moyen d'un plot de mousse.

Le document US 5 420 377 divulgue un circuit comprenant un support de circuit et une plage de soudure ; le support de circuit comprend en outre au moins un évent formé dans le support de circuit pour évacuer les gaz développés pendant une étape de brasage d'un composant ou d'un contact à une plage de soudure.

L'objet de la présente invention vise ainsi à résoudre au moins en partie les inconvénients précités, menant en outre à d'autres avantages.

L'invention est définie dans la revendication indépendante 1, définissant une carte électronique, et dans la revendication indépendante 9, définissant un procédé de réalisation d'une carte électronique.

A cet effet, est proposée selon un premier aspect, une carte électronique comportant au moins un ensemble comportant au moins un support flexible et un circuit imprimé sur le support flexible, dit FPC, le FPC comportant au moins une plaque de contact en surface du support, l'ensemble étant caractérisé en ce qu'il comporte en outre au moins un plot, fixé sur la plaque de contact, et configuré pour établir une connexion électrique avec un composant électronique.

Le plot est un élément préformé. Il s'agit en particulier d'un élément rigide. Le préformage confère au plot une géométrie très bien contrôlée, ce qui se traduit par de bien meilleurs rendements de procédé, en particulier en cas d'étape d'usinage et/ou d'enrobage.

Malgré la souplesse du support du FPC, un tel plot s'est en pratique avéré facile d'utilisation et fiable pour établir une connexion électrique avec une plaque de contact.

La plaque de contact est par exemple une extrémité d'une piste conductrice du circuit imprimé du FPC.

Le plot est par exemple de forme cylindrique, c'est-à-dire qu'il comporte typiquement deux surfaces parallèles dont l'une est fixée sur la plaque de contact.

La géométrie cylindrique permet d'obtenir une surface de contact constante quelle que soit la profondeur d'usinage éventuelle à l'intérieur de la carte.

En conséquence, la connexion électrique entre la plaque de contact et le composant électronique est mieux maitrisée.

De préférence le plot est un cylindre à section circulaire.

Selon l'invention, le plot comporte un coeur en cuivre.

Un tel plot est ainsi particulièrement économique et facile à réaliser.

Selon l'invention, le plot comporte un revêtement en nickel, qui revêt le coeur, et/ou un revêtement d'or.

Un tel traitement à l'or améliore davantage la connexion électrique au FPC.

Le revêtement d'or est de préférence déposé sur le revêtement de nickel si le plot en comporte.

Le plot est par exemple « monté en surface » du support du FPC (ce qui est généralement désigné par l'expression « SMT (Surface Mounting Technology) »).

Pour cela, un équipement à haute vitesse (« standard high speed SMT equipment ») peut être utilisé.

Selon un exemple de réalisation, le plot est soudé à la plaque de contact du FPC.

Par exemple, l'ensemble comporte une couche de pâte de soudure entre le plot et la plaque de contact.

La pâte de soudure fixant le plot à la plaque de contact du FPC est de préférence un alliage conducteur sans plomb, par exemple un alliage conducteur à base d'étain et d'argent et/ou de cuivre.

En pratique, pour réaliser la soudure, cet alliage est par exemple chauffé entre 200°C et 250°C, de préférence à 220°C environ.

Dans un exemple de réalisation privilégié, la couche de pâte de soudure a une épaisseur égale ou inférieure à 50 µm, et de préférence égale à environ 20 µm.

La carte électronique comporte typiquement un corps ; il s'agit par exemple d'un corps conforme aux normes en vigueur, notamment ISO 7810 et ISO 7816.

Selon la norme ISO 7816, un corps de carte peut avoir plusieurs formats, également normalisés. Quatre formats standardisés, connus sous les désignations suivantes (voir notamment la norme ETSI TS 102 221 et la norme ISO 7816), sont principalement utilisés :
- ID-1 ayant une longueur de 85,6 mm, une largeur de 54 mm, et une épaisseur de 0,76 mm ; ce format est parfois désigné par 1FF (pour « premier facteur de forme ») ;
- ID-000 (aussi appelée Plug-in UICC, ou carte SIM GSM) ayant une longueur de 25 mm, une largeur de 15 mm, et la même épaisseur de 0,76 mm ; ce format est parfois désigné par 2FF (pour « deuxième facteur de forme ») ;
- Mini-UICC (parfois aussi appelée carte SIM), avec une longueur de 15 mm, une largeur de 12 mm et la même épaisseur de 0,76 mm ; ce format est parfois désigné par 3FF (pour « troisième facteur de forme ») ;
- Un quatrième format, encore plus petit, appelé nano-SIM ou 4FF (pour « quatrième facteur de forme »), dont le corps de carte mesure 12,3 mm x 8,8 mm x 0,67 mm.

Il faut préciser que les notions de longueur et de largeur sont définies par référence à l'orientation du microcircuit.

Les tolérances de l'ensemble des cartes décrites ci-dessus sont de l'ordre de 0,1 mm.

L'ensemble est par exemple noyé dans le corps de la carte électronique.

L'ensemble est ici noyé dans une résine.

En particulier, l'ensemble est par exemple disposé dans une ouverture d'une couche intermédiaire, et l'ensemble et la couche intermédiaire sont noyés dans une résine, par exemple une résine polyuréthane (PU).

En outre, l'ensemble noyé dans une résine est ici laminé entre deux couches formant au moins en partie le corps de carte.

Les deux couches sont alors disposées de part et d'autre de la résine enrobant l'ensemble.

Au moins l'une des deux couches est par exemple en PVC ou PET ou polycarbonate. Les couches peuvent être constituées d'un même matériau ou de différents matériaux selon la carte à réaliser.

Optionnellement, le corps peut aussi comporter au moins une couche, couramment appelée « overlay », par exemple en PVC, disposée sur au moins l'une des couches laminées. En particulier, la carte peut comporter deux couches « overlay » disposées de part et d'autre de l'ensemble laminé entre deux couches.

La carte électronique comporte en outre au moins un composant électronique connecté électriquement au plot de l'ensemble.

Généralement, plusieurs composants électroniques sont présents.

Le composant électronique est intégré dans le corps, soit au sein du corps, soit dans une cavité formée dans le corps et débouchant à une surface du corps.

Ainsi, dans un exemple de réalisation, le composant électronique est noyé dans le corps de la carte, généralement il est intégré entre deux couches formant une partie du corps de carte.

Dans un autre exemple de réalisation, la carte comporte une cavité, formée dans le corps de la carte.

En particulier, il s'agit alors d'une cavité débouchant à une surface du corps de carte, c'est-à-dire une cavité ouverte.

Une surface du plot est apparente dans la cavité.

Par exemple, une surface supérieure du plot forme au moins une partie d'un fond de la cavité.

Dans un exemple de réalisation privilégié, le composant électronique connecté électriquement au plot est un module qui est encarté dans la cavité.

Dans un exemple de réalisation particulier, le module comporte des zones de contact sur une face externe.

La norme ISO 7816 précise par exemple la configuration d'un tel module au sein d'un corps de carte.

Selon la norme ISO 7816, un tel module peut comporter un film porteur, aussi appelé, selon les cas, substrat isolant, ou vignette, ou plaquette flexible, etc.

Le film comporte une face, dite face extérieure, car elle est destinée à être accessible de l'extérieur de la carte qui sera équipée de ce module, et une face, dite face intérieure, opposée à la face extérieure, et destinée à être orientée vers l'intérieur d'une cavité ménagée dans la carte pour recevoir le module.

La face extérieure comporte par exemple des zones de contact selon une configuration bien définie.

La face intérieure porte par exemple des points de contact connectés électriquement à au moins une partie des zones de contact de la face extérieure.

La configuration des zones de contact de la face extérieure est habituellement conforme à la norme ISO 7816 qui prévoit la présence de huit zones de contact réparties en deux séries parallèles de quatre zones de contact ayant des fonctions bien définies ; ces zones de contact sont habituellement désignées par les références C1 à C8 :
- la zone de contact C1 étant destinée à recevoir une tension d'alimentation notée Vcc (ou Vdd), encore appelé « l'alimentation positive » ;
- la zone de contact C2 étant destinée à recevoir un signal d'initialisation ou remise à zéro de la puce, noté RST ;
- la zone de contact C3 étant destinée à recevoir un signal d'horloge noté CLK ;
- la zone de contact C4 étant destinée à recevoir un signal dépendant de l'application visée ;
- la zone de contact C5 étant destinée à recevoir une tension de masse notée GND (ou Vss), encore appelée la « terre » ;
- la zone de contact C6 étant destinée à recevoir une tension de programmation de carte à mémoire notée VPP pour un protocole de communication SWP (« Single Wire Protocole ») ;
- la zone de contact C7, encore appelé I/O, étant destinée à recevoir un signal d'entrée/sortie d'échange de données avec la puce ; et
- la zone de contact C8 étant destinée à coopérer avec la zone C4 en fonction de l'application visée.

Les zones de contact C4 et C8 n'ont pas toujours été utilisées dans le passé, mais le sont de plus en plus, notamment pour des communications USB, ou pour des communications SPI.

En fait une version révisée de la norme ISO 7816 (version 7816-2&10&12) précise que la plage C4 peut avoir une fonction de reset, d'écriture ou de lecture, ou de borne D+ pour une fonction USB, tandis que la plage C8 peut avoir une fonction de borne D- pour une fonction USB.

La norme ISO 7816-2 fixe en outre les positions réciproques des diverses zones de contact, ainsi que les dimensions minimales de ces zones de contact, à savoir 2 mm de large et 1,7 mm de haut (par convention, les plages sont disposées en séries verticales, près des petits côtés du film porteur (qui a une forme globalement rectangulaire avec des coins arrondis).

Dans un autre exemple de réalisation particulier, le module comporte un capteur, ou un afficheur, ou encore une LED.

Ainsi, dans un mode de réalisation privilégié ici, la face interne du module peut comporter au moins une plaque de contact, et celle-ci est connectée avec un capteur, un afficheur, ou encore une LED, de la face externe du module.

La connexion est par exemple établie par au moins un via métallisé, traversant le film porteur.

Un capteur d'un tel module comporte par exemple un capteur biométrique, comme un capteur d'empreinte digitale.

Un afficheur est par exemple configuré pour afficher un code de carte à usage unique, par exemple trois digits qui se rafraîchissent à intervalles de temps établis.

Par exemple, la carte électronique a plusieurs modes de fonctionnement et comporte un actionneur, par exemple un bouton, configuré pour sélectionner un des modes de fonctionnement de la carte.

Et par exemple, la carte comporte autant de LED qu'elle a de modes de fonctionnement.

Ainsi, une LED permet par exemple d'identifier le mode de fonctionnement sélectionné ou actif.

Par exemple, le FPC peut aussi comporter une puce.

La carte électronique considérée est par exemple une carte complexe.

Selon encore un autre aspect, est également proposé un procédé de réalisation d'une carte électronique telle que décrite précédemment, comportant des étapes de réalisation d'un ensemble, comportant :
- une étape de fourniture d'un circuit imprimé sur un support flexible, dit FPC, comportant au moins une plaque de contact en surface du support ;
- une étape de fourniture d'un plot préformé, le plot comportant un coeur en cuivre et au moins un revêtement de nickel et/ou un revêtement d'or ; et
- une étape de placement et fixation du plot sur la plaque de contact.
et comportant en outre :
- une étape de noyage de l'ensemble dans une résine,
- puis une étape de laminage de l'ensemble noyé dans la résine entre deux couches disposées de part et d'autre de l'ensemble noyé dans la résine ; et
- une étape de connexion électrique du composant électronique au plot du FPC.

Dans un exemple de mise en oeuvre particulier, le procédé comporte aussi une étape de répartition d'une couche de pâte de soudure sur au moins une partie de la plaque de contact et une étape de soudure du plot à la plaque de contact.

Par exemple, dans l'étape de répartition, la pâte de soudure est étalée sur au moins une partie de la plaque de contact avec une épaisseur égale ou inférieure à 50 µm, et de préférence égale à environ 20 µm.

L'étape de soudure comporte par exemple une étape de chauffage de la pâte de soudure à une température comprise entre 200°C et 250°C, de préférence à 220°C environ.

La pâte de soudure utilisée est de préférence un alliage conducteur sans plomb, par exemple un alliage conducteur à base d'étain et d'argent et/ou de cuivre.

Dans un exemple de mise en oeuvre particulier, le procédé comporte en outre une étape de formation d'une cavité débouchante, une surface du plot apparaissant dans la cavité.

Par exemple, l'étape de formation de la cavité comporte une étape d'usinage d'une partie du corps de carte, et éventuellement d'une partie du plot.

Dans un exemple de mise en oeuvre intéressant, le procédé comporte en outre une étape d'encartage du composant électronique, qui est alors un module, dans la cavité de la carte électronique, et l'étape de connexion électrique comporte une connexion électrique du composant électronique à la surface du plot apparaissant dans la cavité.

L'invention, selon un exemple de réalisation, sera bien comprise et ses avantages apparaitront mieux à la lecture de la description détaillée qui suit, donnée à titre indicatif et nullement limitatif, en référence aux dessins annexés dans lesquels :
La figure 1 représente un exemple de réalisation de bosses pour une soudure avec un composant électronique sur un FPC selon l'état de l'art ;
La figure 2 illustre schématiquement une étape de procédé de réalisation d'un ensemble comportant un FPC selon un exemple de mise en oeuvre de l'invention ;
La figure 3 représente schématiquement un exemple d'ensemble comportant un FPC selon l'invention ;
La figure 4 illustre schématiquement un corps de carte comportant l'ensemble de la figure 2 selon un exemple de mise en oeuvre de l'invention ;
La figure 5 illustre schématiquement un exemple de réalisation d'une cavité dans le corps de la figure 4 selon un exemple de mise en oeuvre de l'invention ;
La figure 6 illustre schématiquement une étape d'encartage d'un module selon un exemple de mise en oeuvre de l'invention ; et
La figure 7 représente schématiquement une carte électronique selon un exemple de mise en oeuvre de l'invention.

Les éléments identiques représentés sur les figures précitées sont identifiés par des références numériques identiques.

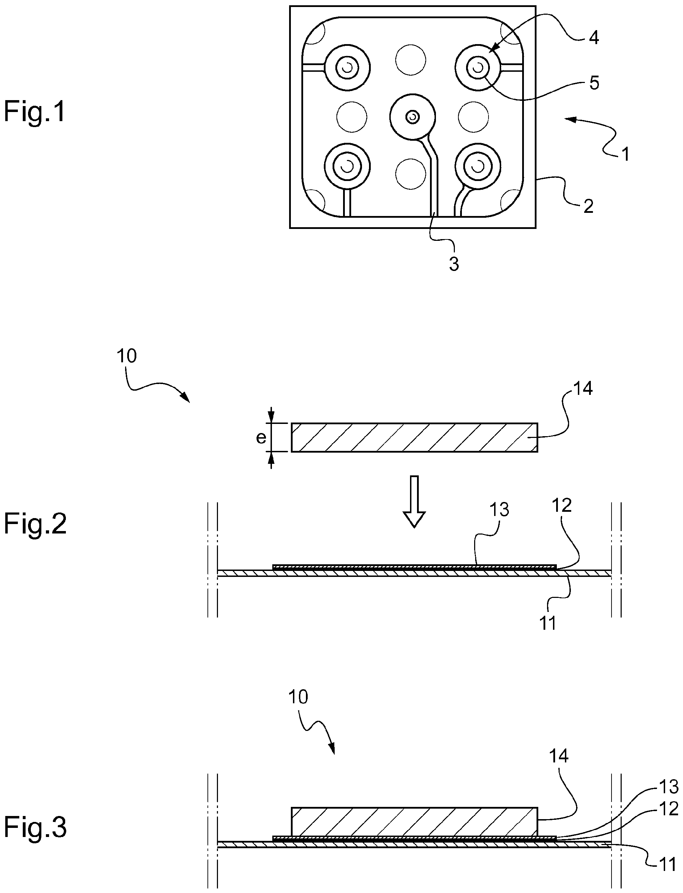

La figure 1 représente un FPC 1 (pour « flexible printed circuit »), c'est-à-dire un circuit imprimé sur un support flexible. De manière traditionnelle, le FPC 1 comporte un support 2, relativement souple et flexible, et un circuit électronique 3 (i.e. principalement des pistes, généralement en cuivre) imprimé sur le support 2. Pour établir un contact électrique avec un composant électronique, le circuit électronique 3 comprend généralement au moins une plaque de contact (non visible sur la figure 1), généralement plusieurs.

Selon l'état de l'art, afin d'établir une connexion électrique entre le circuit électronique 3 et un composant électronique (initialement indépendant du FPC), une goutte de pâte de soudure est déposée sur une plaque de contact du circuit électronique 3.

La goutte durcit, et forme alors pas définition une bosse 4. Afin de réaliser une surface de contact 5 à laquelle le composant électronique est ensuite relié pour établir la connexion électrique avec le circuit électronique 3, la bosse est usinée, par exemple par fraisage.

Or, du fait de leur dépôt à l'état liquide, les gouttes, et a fortiori les bosses correspondantes, présentent des hauteurs très variables par rapport à la surface du FPC sur laquelle elles sont déposées.

En conséquence, lorsque l'usinage est réalisé, typiquement jusqu'à une hauteur prédéfinie par rapport à la surface du FPC, la bosse est affectée sur une distance plus ou moins importante par rapport à son sommet. Il en résulte que la surface de contact 5 présente une taille variable.

Ce phénomène est illustré sur la figure 1 où, parmi les cinq bosses représentées, la bosse du milieu présente une surface de contact plus petite que les autres, tandis que celle de la bosse en bas à gauche est plus grande.

Pour remédier aux difficultés engendrées par ces disparités, la présente invention vise à proposer un FPC où une telle bosse est remplacée par un plot 14 préformé.

La figure 2 illustre la réalisation d'un ensemble 10 comportant un FPC 11, 12, selon l'invention.

Le FPC 11, 12 comporte, comme habituellement, un support 11, relativement souple et flexible, et un circuit électronique (i.e. principalement des pistes, généralement en cuivre), non représenté ici, imprimé sur le support 11.

Dans un exemple de réalisation particulier, une des pistes du circuit électronique peut être une antenne.

Le support présente, par définition, une largeur et une hauteur, inférieures aux dimensions correspondantes du corps de carte auquel il est destiné, et une épaisseur, très inférieure à l'épaisseur de ce corps de carte. La largeur et la hauteur du FPC permettent de définir un contour du support du FPC.

Le support 11 du FPC peut être considéré comme une feuille. Il présente une certaine souplesse.

Le support 11 est par exemple réalisé en un matériau polymère, par exemple en polyimide, ou en tout autre matériau ayant de préférence une élasticité comparable, par exemple en Kapton^{®}.

Pour établir un contact électrique avec un composant électronique, le circuit électronique comprend au moins une plaque de contact 12 en surface du support 11.

Dans la représentation schématique des présentes figures, seule une plaque de contact 12 est représentée, mais il peut bien entendu y en avoir plusieurs.

Selon l'invention, pour établir ultérieurement une connexion électrique avec un composant électronique, un plot 14 est placé sur au moins une partie de la plaque de contact 12, de préférence centré par rapport à celle-ci, et y est fixé.

On entend ici par plot un élément préformé et d'épaisseur « e » non négligeable.

Il est ainsi possible de réaliser plusieurs plots, tous identiques, ce qui rend les manipulations plus faciles compte tenu des faibles disparités qu'une série de plots peut présenter d'un plot à un autre.

De préférence, le plot est un élément cylindrique, par exemple à section circulaire.

Dans un exemple de réalisation privilégié, le plot comporte un coeur en cuivre, un revêtement en nickel qui revêt le coeur et aussi un revêtement d'or appliqué sur le revêtement de nickel afin de favoriser les conductions électriques.

La fixation du plot 14 à la plaque de contact 12 est par exemple réalisée par soudure.

A cet effet, une couche mince de pâte de soudure 13 peut être appliquée et étalée sur au moins une partie de la plaque de contact 12. Une couche mince désigne ici une couche de pâte de soudure 13 qui a une épaisseur négligeable, typiquement de l'ordre de quelques microns, de préférence égale ou inférieure à 50 µm. Le plot 14 est ensuite placé par-dessus, comme l'illustre la figure 3.

La figure 3 représente schématiquement l'ensemble 10 obtenu, prêt à être intégré dans un corps 29 pour la réalisation d'une carte électronique 20.

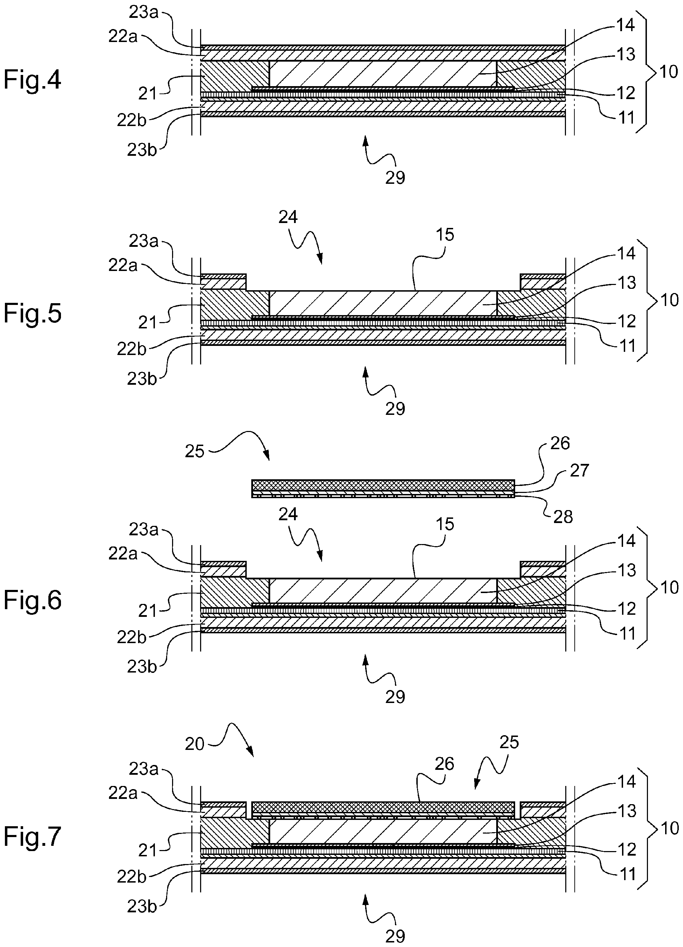

Les principales étapes de réalisation d'une carte électronique 20 comportant un tel ensemble 10 sont illustrées par les figures 4 à 7.

Comme l'illustre la figure 4, pour réaliser une carte électronique, l'ensemble 10, tel que décrit précédemment et représenté figure 3, est enrobé dans une résine 21, puis pris en sandwich entre différentes couches (22a, 22b, 23a, 23b) disposées de part et d'autre de l'ensemble 10.

Dans un exemple de mise en oeuvre, ce tout est ensuite laminé, à chaud ou à froid, de sorte à former un corps 29 de carte électronique. Le corps 29 est ainsi réalisé par assemblage de différentes couches superposées, et l'ensemble 10 est noyé dans le corps 29.

La résine 21 est par exemple du polyuréthane (PU).

Chacune des couches (22a, 22b, 23a, 23b) est par exemple en PVC ou PET ou polycarbonate. Les couches (22a, 22b, 23a, 23b) peuvent être constituées d'un même matériau ou de différents matériaux selon la carte à réaliser, et de même, les matériaux utilisés pour les couches peuvent varier de l'une à l'autre.

Dans le présent exemple de réalisation, le corps 29 tel que représenté figure 4 comporte successivement une couche supérieure 23a, couramment appelée « overlay » supérieur, par exemple ici en PVC, une couche imprimée supérieure 22a, par exemple ici en PVC, puis la couche de résine 21 dans laquelle est noyée l'ensemble 10, puis une couche imprimée inférieure 22b, par exemple ici en PVC, et enfin une couche inférieure 23b, couramment appelée « overlay » inférieur, par exemple ici en PVC.

Ainsi, en d'autres termes, le plot 14 est ici disposé entre le FPC 11, 12 et la couche imprimée supérieure 22a.

Comme l'illustre la figure 4, bien que l'ensemble 10 soit considéré comme noyé dans la résine 21, il est possible qu'une surface du plot 14 (par exemple sa surface supérieure) soit toutefois tangente à la couche imprimée supérieure 22a.

Ainsi, à l'issue de ces étapes de réalisation, un corps 29 de carte électronique est formé, comme représenté figure 4.

La figure 5 illustre une étape dans laquelle une cavité 24 est formée dans le corps 29.

Ici, la cavité est formée par usinage du corps 29 à partir de la couche supérieure 23a, jusqu'à usiner éventuellement le plot 14 sur une partie de son épaisseur « e ».

Bien entendu, selon un autre exemple de réalisation non représenté, la couche supérieure 23a et la couche imprimée supérieure 22a pourraient comporter une perforation, préalablement à leur assemblage avec l'ensemble 10 ; leurs perforations étant configurées pour être positionnées au regard du plot 14 lorsque la couche supérieure 23a et la couche imprimée supérieure 22a sont assemblées avec l'ensemble 10.

Usiné ou non, une fois la cavité 24 formée, le plot 14 présente une surface supérieure 15 avec laquelle est ensuite établie une connexion électrique.

Une fois la cavité formée, comme l'illustre la figure 6, un composant électronique 25, qui est ici un module, est amené dans la cavité 24.

Dans le présent exemple de réalisation, le composant électronique 25 comporte un capteur 26, comme un capteur biométrique, par exemple un capteur d'empreinte. Selon d'autres exemples, le composant électronique 25 pourrait comporter un afficheur, ou le capteur pourrait être un autre type de capteur biométrique, ou il pourrait s'agir d'un module tel que défini par la norme ISO 7816.

Afin d'être connecté électriquement au plot 14, le composant électronique 25 comporte en outre par exemple une plaque de contact 27.

Afin de réaliser la connexion électrique avec le plot 14, dans le présent exemple de réalisation, une couche d'adhésif électriquement conducteur 28, par exemple ici un adhésif anisotrope (souvent désigné « ACF » pour « anisotropic conductive film »), est disposée entre la plaque de contact 27 et le plot 14, et en particulier ici sur la plaque de contact 27 du composant électronique 25.

L'adhésif électriquement conducteur 28 pourrait aussi être une colle conductrice ou une pâte à braser pour réaliser la connexion électrique entre le composant électronique 25 et le plot 14.

La pâte à braser désigne ici une pâte à basse température de fusion (i.e. environ 100°C). Il s'agit par exemple d'un alliage à base d'étain. Cet alliage redevient visqueux lorsque le module est encarté dans la cavité.

La colle conductrice et la pâte à braser sont des conducteurs électriques dans toutes les directions.

Selon un autre exemple de réalisation, l'adhésif électriquement conducteur 28 n'est déposé que sur le plot 14, en particulier sur sa surface supérieure 15.

En option, la surface entre la plaque de contact 27 et un fond de la cavité 24 qui entoure la surface supérieure 15 du plot 14 peut être maintenue par un adhésif, lequel est généralement différent de l'adhésif électriquement conducteur 28, et notamment électriquement isolant.

La figure 7 présente schématiquement une carte électronique 20, par exemple telle qu'obtenue à l'issue d'un procédé tel que décrit précédemment.

Il s'agit par exemple d'une carte électronique conforme aux normes en vigueur, notamment ISO 7810 et ISO 7816.

La carte électronique 20 comporte ainsi principalement le corps 29 et le composant électronique 25, qui est par exemple un module, encarté dans la cavité 24 du corps 29.

La connexion électrique entre le composant électronique 25 et le circuit électronique imprimé du FPC 11, 12 est alors établie grâce au plot 14, d'un côté soudé à la plaque de contact 12 du FPC et d'un autre côté collé au composant électronique 25 par l'ACF 28.

## Revendications

1. Carte électronique (20) comportant au moins :
- un ensemble (10) comportant au moins un support flexible (11) et un circuit imprimé sur le support flexible, dit FPC (11,12), le FPC comportant au moins une plaque de contact (12) en surface du support (11), et l'ensemble (10) comportant en outre au moins un plot (14) fixé sur la plaque de contact (12) configuré pour établir une connexion électrique avec un composant électronique (25), l'ensemble (10) étant noyé dans une résine (21) et laminé entre deux couches (22a, 22b), et
- le composant électronique (25) connecté électriquement au plot (14) de l'ensemble (10),
**caractérisé en ce que** le plot (14) comportant un coeur en cuivre et au moins un revêtement de nickel et/ou un revêtement d'or.

2. Carte électronique (20) selon la revendication 1, **caractérisée en ce que** la carte électronique (20) comporte une cavité (24), une surface (15) du plot (14) étant apparente dans la cavité (24), et **en ce que** le composant électronique (25) connecté électriquement au plot (14) est un module qui est encarté dans la cavité (24).

3. Carte électronique (20) selon la revendication 2, **caractérisée en ce que** le module comporte un capteur (27), ou un afficheur, ou encore une LED, ou encore **en ce que** le module comporte des zones de contact sur une face externe.

4. Carte électronique (20) selon l'une quelconque des revendications 2 ou 3, **caractérisée en ce qu'**une surface supérieure (15) du plot (14) forme au moins une partie d'un fond de la cavité (24).

5. Carte électronique (20) selon l'une quelconque des revendications 1 à 4, **caractérisée en ce que** le plot (14) est de forme cylindrique.

6. Carte électronique (20) selon l'une quelconque des revendications 1 à 5, **caractérisée en ce qu'**il comporte une couche de pâte de soudure (13) entre le plot (14) et la plaque de contact (12).

7. Carte électronique (20) selon la revendication 6, **caractérisée en ce que** la pâte de soudure utilisée est un alliage conducteur sans plomb, par exemple un alliage conducteur à base d'étain et d'argent et/ou de cuivre.

8. Carte électronique (20) selon l'une quelconque des revendications 1 à 7, **caractérisée en ce que** le composant électronique (25) comporte une plaque de contact (27), une couche d'adhésif électriquement conducteur (28) étant disposée sur la plaque de contact (27) du composant électronique (25), entre la plaque de contact (27) et le plot (14).

9. Procédé de réalisation d'une carte électronique (20) selon l'une quelconque des revendications 1 à 8 comportant :
des étapes de réalisation d'un ensemble (10) comportant :
- une étape de fourniture d'un circuit imprimé sur un support flexible (11), dit FPC (11,12), comportant au moins une plaque de contact (12) en surface du support (11) ;
- une étape de fourniture d'un plot (14) préformé ; et
- une étape de placement et fixation du plot (14) sur la plaque de contact (12) ;
et comportant en outre :
- une étape de noyage de l'ensemble (10) dans une résine (21),
- puis une étape de laminage de l'ensemble (10) noyé dans la résine (21) entre deux couches (22a,22b) disposées de part et d'autre de l'ensemble (10) noyé dans la résine (21) ; et
- une étape de connexion électrique du composant électronique (25) au plot (14),
le procédé étant **caractérisé en ce que** le plot (14) comportant un coeur en cuivre et au moins un revêtement de nickel et/ou un revêtement d'or.

10. Procédé selon la revendication 9 comportant une étape de répartition d'une couche de pâte de soudure (13) sur au moins une partie de la plaque de contact (12) et une étape de soudure du plot (14) à la plaque de contact (12).

11. Procédé selon l'une quelconque des revendications 9 ou 10, **caractérisé en ce qu'**il comporte en outre une étape de formation d'une cavité débouchante (24), une surface (15) du plot (14) apparaissant dans la cavité (24), et une étape d'encartage du composant électronique (25) dans la cavité (24) de la carte électronique (20), et une étape de connexion électrique du composant électronique (25) à la surface (15) du plot (14) apparaissant dans la cavité.

12. Procédé selon la revendication 11, dans lequel l'étape de formation de la cavité comporte une étape d'usinage d'une partie du corps de carte.

13. Procédé selon la revendication 12, dans lequel l'étape de formation de la cavité comporte une étape d'usinage d'une partie du plot (14).

## Patentansprüche

1. Elektronische Platine (20), die mindestens Folgendes umfasst:
- eine Anordnung (10), die mindestens einen flexiblen Träger (11) und eine gedruckte Schaltung auf dem flexiblen Träger, als FPC (11, 12) bezeichnet, umfasst, wobei die FPC mindestens eine Kontaktplatte (12) auf der Oberfläche des Trägers (11) umfasst, und wobei die Anordnung (10) ferner mindestens ein Pad (14) umfasst, das auf der Kontaktplatte (12) befestigt ist und dazu konfiguriert ist, eine elektrische Verbindung mit einer elektronischen Komponenten (25) herzustellen, wobei die Anordnung (10) in einem Harz (21) eingebettet und zwischen zwei Schichten (22a, 22b) laminiert ist, und
- die elektronische Komponente (25), die mit dem Pad (14) der Anordnung (10) elektrisch verbunden ist, **dadurch gekennzeichnet, dass** das Pad (14) einen Kern aus Kupfer und mindestens eine Beschichtung aus Nickel und/oder eine Beschichtung aus Gold umfasst.

2. Elektronische Platine (20) nach Anspruch 1, **dadurch gekennzeichnet, dass** die elektronische Platine (20) eine Ausnehmung (24) umfasst, wobei eine Oberfläche (15) des Pads (14) in der Ausnehmung (24) sichtbar ist, und dass die elektronische Komponente (25), die mit dem Pad (14) elektrisch verbunden ist, ein Modul ist, das in die Ausnehmung (24) eingesetzt ist.

3. Elektronische Platine (20) nach Anspruch 2, **dadurch gekennzeichnet, dass** das Modul einen Sensor (27) oder eine Anzeige oder auch eine LED umfasst, oder auch dass das Modul Kontaktbereiche auf einer Außenseite umfasst.

4. Elektronische Platine (20) nach einem beliebigen der Ansprüche 2 oder 3, **dadurch gekennzeichnet, dass** eine obere Oberfläche (15) des Pads (14) mindestens einen Teil eines Bodens der Ausnehmung (24) bildet.

5. Elektronische Platine (20) nach einem beliebigen der Ansprüche 1 bis 4, **dadurch gekennzeichnet, dass** das Pad (14) eine zylindrische Form aufweist.

6. Elektronische Platine (20) nach einem beliebigen der Ansprüche 1 bis 5, **dadurch gekennzeichnet, dass** sie eine Lötpastenschicht (13) zwischen dem Pad (14) und der Kontaktplatte (12) umfasst.

7. Elektronische Platine (20) nach Anspruch 6, **dadurch gekennzeichnet, dass** die verwendete Lötpaste eine bleifreie leitende Legierung, beispielsweise eine leitende Legierung auf Basis von Zinn und Silber und/oder Kupfer, ist.

8. Elektronische Platine (20) nach einem beliebigen der Ansprüche 1 bis 7, **dadurch gekennzeichnet, dass** die elektronische Komponente (25) eine Kontaktplatte (27) umfasst, wobei eine elektrisch leitende Klebstoffschicht (28) auf der Kontaktplatte (27) der elektronischen Komponente (25) zwischen der Kontaktplatte (27) und dem Pad (14) angeordnet ist.

9. Verfahren zur Herstellung einer elektronischen Platine (20) nach einem beliebigen der Ansprüche 1 bis 8, das Folgendes umfasst:
Schritte zur Herstellung einer Anordnung (10), die Folgendes umfassen:
- einen Schritt des Bereitstellens einer gedruckten Schaltung auf einem flexiblen Träger (11), als FPC (11, 12) bezeichnet, die mindestens eine Kontaktplatte (12) auf der Oberfläche des Trägers (11) umfasst;
- einen Schritt des Bereitstellens eines vorgeformten Pads (14); und
- einen Schritt des Platzierens und Befestigens des Pads (14) auf der Kontaktplatte (12);
und ferner umfassend:
- einen Schritt des Einbettens der Anordnung (10) in einem Harz (21),
- dann einen Schritt des Laminierens der in dem Harz (21) eingebetteten Anordnung (10) zwischen zwei Schichten (22a, 22b), die auf beiden Seiten der in dem Harz (21) eingebetteten Anordnung (10) angeordnet sind; und
- einen Schritt des elektrischen Verbindens der elektronischen Komponente (25) mit dem Pad (14), wobei das Verfahren **dadurch gekennzeichnet ist, dass** das Pad (14) einen Kern aus Kupfer und mindestens eine Beschichtung aus Nickel und/oder eine Beschichtung aus Gold umfasst.

10. Verfahren nach Anspruch 9, das einen Schritt des Verteilens einer Lötpastenschicht (13) auf mindestens einem Teil der Kontaktplatte (12) und einen Schritt des Lötens des Pads (14) an die Kontaktplatte (12) umfasst.

11. Verfahren nach einem beliebigen der Ansprüche 9 oder 10, **dadurch gekennzeichnet, dass** es ferner Folgendes umfasst: einen Schritt des Bildens einer offenen Ausnehmung (24), wobei eine Oberfläche (15) des Pads (14) in der Ausnehmung (24) sichtbar ist, und einen Schritt des Einsetzens der elektronischen Komponente (25) in die Ausnehmung (24) der elektronische Platine (20) und einen Schritt des elektrischen Verbindens der elektronischen Komponente (25) mit der Oberfläche (15) des Pads (14), die in der Ausnehmung sichtbar ist.

12. Verfahren nach Anspruch 11, wobei der Schritt des Bildens der Ausnehmung einen Schritt des Bearbeitens eines Teils des Körpers der Platine umfasst.

13. Verfahren nach Anspruch 12, wobei der Schritt des Bildens der Ausnehmung einen Schritt des Bearbeitens eines Teils des Pads (14) umfasst.

## Claims

1. Electronic board (20) comprising at least:
- an assembly (10) comprising at least a flexible support (11) and a printed circuit on the flexible support and known as a flexible printed circuit or FPC (11, 12), the FPC comprising at least one contact plate (12) at the surface of the support (11), and the assembly (10) further comprising at least one stud (14) fixed to the contact plate (12) and configured to establish an electrical connection with an electronic component (25), the assembly (10) being encapsulated in a resin (21) and laminated between two layers (22a, 22b), and
- the electronic component (25) electrically connected to the stud (14) of the assembly (10), **characterized in that** the stud (14) has a copper core and at least a nickel coating and/or gold coating.

2. Electronic board (20) according to Claim 1, **characterized in that** the electronic board (20) comprises a cavity (24), a surface (15) of the stud (14) being visible in the cavity (24), and **in that** the electronic component (25) electrically connected to the stud (14) is a module which is embedded in the cavity (24).

3. Electronic board (20) according to Claim 2, **characterized in that** the module comprises a sensor (27), or a display, or else an LED, or else **in that** the module comprises contact zones on an external face.

4. Electronic board (20) according to either one of Claims 2 or 3, **characterized in that** an upper surface (15) of the stud (14) forms at least part of the bottom of the cavity (24).

5. Electronic board (20) according to any one of Claims 1 to 4, **characterized in that** the stud (14) is cylindrical in shape.

6. Electronic board (20) according to any one of Claims 1 to 5, **characterized in that** it comprises a layer of solder paste (13) between the stud (14) and the contact plate (12).

7. Electronic board (20) according to Claim 6, **characterized in that** the solder paste used is a lead-free conductive alloy, for example a conductive alloy based on tin and silver and/or copper.

8. Electronic board (20) according to any one of Claims 1 to 7, **characterized in that** the electronic component (25) comprises a contact plate (27), an electrically-conducting adhesive layer (28) being placed on the contact plate (27) of the electronic component (25), between the contact plate (27) and the stud (14).

9. Method for producing an electronic board (20) according to any one of Claims 1 to 8, comprising:
steps of producing an assembly (10) comprising:
- a step of providing a printed circuit on a flexible support (11), known as a flexible printed circuit or FPC (11, 12), comprising at least one contact plate (12) at the surface of the support (11);
- a step of providing a preformed stud (14); and
- a step of placing and fixing the stud (14) on the contact plate (12);
and further comprising:
- a step of encapsulating the assembly (10) in a resin (21),
- then a step of laminating the assembly (10) encapsulated in the resin (21) between two layers (22a, 22b) placed one on each side of the assembly (10) encapsulated in the resin (21); and
- a step of electrically connecting the electronic component (25) to the stud (14), the method being **characterized in that** the stud (14) has a copper core and at least a nickel coating and/or gold coating.

10. Method according to Claim 9, comprising a step of spreading a layer of solder paste (13) over at least part of the contact plate (12) and a step of soldering the stud (14) to the contact plate (12).

11. Method according to either one of Claims 9 or 10, **characterized in that** it further comprises a step of forming an open-ended cavity (24), a surface (15) of the stud (14) being visible in the cavity (24), and a step of embedding the electronic component (25) in the cavity (24) of the electronic board (20), and a step of electrically connecting the electronic component (25) to the surface (15) of the stud (14) visible in the cavity.

12. Method according to Claim 11, wherein the step of forming the cavity comprises a step of machining part of the card body.

13. Method according to Claim 12, wherein the step of forming the cavity comprises a step of machining part of the stud (14).
